# EUROPEAN PATENT SPECIFICATION

(11) **EP 2 381 475 B1**
(45) Date of publication and mention of the grant of the patent: **04.03.2015**
(21) Application number: 11163603.1
(22) Date of filing: 22.04.2011
(51) Int. Cl.: H01L 25/065, H01L 27/144, H01L 27/146

(54) **Method of managing a silicon photomultiplier device**
Verfahren zur Verwaltung eines Silizium-Fotovervielfacherbauelement
Méthode de fonctionnement d'un dispositif photomultiplicateur en silicium

(30) Priority: 22.04.2010 IT VI20100110
(43) Date of publication of application: 26.10.2011
(73) Proprietor: Fondazione Bruno Kessler, 38122 Trento (IT)
(72) Inventor: Piemonte, Claudio, 38057, PERGINE VALSUGANA (TN) (IT)
(74) Representative: Bonini, Ercole

(56) References cited:
- EP-A1- 1 840 967
- US-A1- 2004 129 991
- US-A1- 2006 035 402
- US-A1- 2008 308 928

## Description

The invention concerns a method for managing an improved silicon photomultiplier device (SiPM) particularly suited to detect one or more photons incident on the sensitive surface of the above mentioned device.

It is known that there are many fields of application in which it is necessary to detect very low intensity light.

In the medical sector, for example, said need is present in the equipment applying the technique known as positron emission tomography (PET), through which it is possible to obtain bio-images that allow the creation of maps of the functional processes that take place inside the body.

In particular, according to said technique, a tracer isotope is administered to the patient subjected to the examination and after a decay and annihilation process carried out by means of electrons said isotope causes two photons to be emitted in opposite directions.

Said photons, when they reach a scintillator material placed in the scanner device, produce a light flash that is detected by said photomultiplier devices.

In these specific cases, as well as in other applications, the purpose is to "count" the number of photons and usually also to determine, as precisely as possible, the instant of time of arrival of the high-energy particle.

In order to allow this data to be detected, it is therefore necessary to use high-resolution photomultiplier devices having limited or no problems related to sensitivity to intrinsic and/or external interferences.

From this last point of view, photomultiplier tubes or "PMT" have been known and used for years as detecting devices, said photomultiplier tubes being vacuum devices characterized by high gain (number of electrons produced per photon) and high response speed.

However, said devices pose a series of drawbacks that are described below. A first drawback lies in that said devices have a given, not negligible size that does not facilitate their integration in a complex system.

Furthermore, from the structural point of view said photomultiplier tubes are disadvantageously rather fragile.

Finally, a further drawback lies in that said devices are very sensitive to external magnetic fields that can deviate the path of the electrons inside them and thus affect the precision of the measurement.

In order to overcome this series of drawbacks, silicon devices have been recently developed, which in technical jargon are called "silicon photomultipliers" or "SiPMs" and hereinafter are simply called photomultiplier devices, if not indicated otherwise, comprising a plurality of photodiodes (usually arranged in a matrix), made on a single semiconductor substrate and operating in Geiger mode.

The surface of said photomultiplier devices is thus sensitive to the photons incident on it and in particular each photodiode responds independently of the others, emitting an elementary charge packet where a photon is detected.

In general, as previously mentioned, silicon photomultiplier devices present higher compactness, sturdiness, integrability in the system and insensitivity to magnetic fields compared to photomultiplier tubes (PMT).

It is also known that at present there are two types of silicon photomultiplier devices, depending on how the signals of the individual photodiodes are treated.

A first type consists of digital photomultiplier devices, in which the signals of the individual photodiodes are digitized locally and sent to a logic unit positioned on the same surface on which there are said photodiodes.

Said logic unit outputs the data concerning the detection of incident photons. The second type of photomultiplier devices is analog and its output is a single analog signal proportional to the number of activated photodiodes (on which incidence of one or more photons has taken place).

For this purpose, the above mentioned photodiodes of this last type of photomultiplier devices are connected in parallel to one another and each one of them has an integrated series resistor of a few hundred kilo-ohm serving as quenching circuit for the same photodiode.

The two above mentioned types of silicon photomultiplier devices present mutual advantages and disadvantages with respect to each other, which are described here below.

Advantageously, the photomultiplier devices of the digital type, output signals that are immune to external interferences from each photodiode, contrary to what may happen with the analog photomultiplier devices in which the resulting analog signal can be subjected to distortions.

Finally, a further advantage offered by digital photomultipliers compared to analog multipliers lies in that their temporal resolution is independent of the dimensions of the device.

On the other hand, analog photomultiplier devices are simpler to construct and to manage than digital photomultiplier devices.

Therefore, the photomultiplier devices of the analog type have lower construction costs than the digital ones and therefore in some situations their use is preferable even though their efficiency is lower.

Furthermore, the sensitive surface of analog photomultipliers is independent of the logic unit that manages the output signals of the photodiodes, as the connection between the two entities is carried out through discrete connection means (wire bonds or similar), differently from the digital photomultiplier devices in which the logic unit, as already mentioned above, is usually obtained on the same surface on which the photodiodes are provided. Consequently and advantageously, with analog photomultiplier devices it is possible to intervene on the logic unit independently of the sensitive surface and vice versa.

Furthermore, the fact that digital photomultiplier devices have the logic unit on the surface where the photodiodes are provided determines the presence of a "dead area" insensitive to photon incidence that, in turn, determines a reduced resolution for the entire device.

However, said photomultiplier devices of the analog type have an important acknowledged limitation related to their management.

In fact, if one or more of the photodiodes connected to one another in parallel and present on the sensitive surface of said analog photomultiplier devices are not operating or are noisy, they may affect the output signal of the photomultiplier device.

Disadvantageously, the only way to resolve said malfunction of one or more photodiodes is to replace the entire photomultiplier device.

It is consequently clear that in this situation a large amount of money is wasted as, in the worst case, for a single not operating or noisy photodiode it is necessary to replace an entire photomultiplier device.

The compared analysis of the two types of silicon photomultiplier devices described above makes it possible to understand the drawbacks of the known art.

The present invention aims to overcome the drawbacks listed above.

In particular, it is the object of the invention to propose a method for managing a silicon photomultiplier device that makes it possible to inhibit in a simple manner a sector or, in the limit case, an individual noisy or non operating photodiode that determine the reduction of the overall efficiency.

In the same time, it is a further object of the invention to propose a method for managing a photomultiplier device whose sensitive surface is independent of the logic unit, so as to allow separate intervention on the two entities.

It is another object of the invention to propose a method for managing a photomultiplier device whose sensitive surface has reduced dimensions, though maintaining high resolution.

Furthermore, it is the object of the present invention to propose a method for managing a photomultiplier device whose efficiency and temporal resolution can be compared to those of digital photomultipliers.

The objects described above are achieved by a method for managing a photomultiplier device having the characteristics illustrated in the main claim. Further characteristics of the method of the invention concerning the management of a photomultiplier device that is the subject of the invention are described in the dependent claims.

Advantageously, the photomultiplier device to which the management method of the invention is applied makes it possible to connect the sensitive surface to different types of logic units depending on the use needs.

Consequently, a further advantage is represented by the possibility to construct the photomultiplier device to which the management method of the invention is applied so that it can be modulated with different levels of efficiency from the functional point of view, determining different production costs and selling prices.

US 2004/0129991 describes a front side illuminated photodiode.

The objects and advantages described above will be highlighted in greater detail in the description of a preferred embodiment of the invention that is supplied as an indicative, non-limiting example, with reference to the enclosed drawings, wherein:
- Figure 1 shows an axonometric plan view of the photomultiplier device to which the management method of the invention is applied;
- Figure 2 shows an axonometric view of a detail of the photomultiplier device of Figure 1 to which the management method of the invention is applied;
- Figure 3 shows an axonometric view from below of the photomultiplier device to which the management method of the invention is applied;
- Figure 4 shows the front view of the semiconductor substrate from the sensitive surface side;
- Figure 5 shows the front view of the semiconductor substrate from the side of the extraction points opposite the sensitive surface;
- Figure 6 shows the front view of the photomultiplier device from the logic unit side;
- Figure 7 shows a cross section side view along a transversal plane of the photomultiplier device that is the subject of the invention.

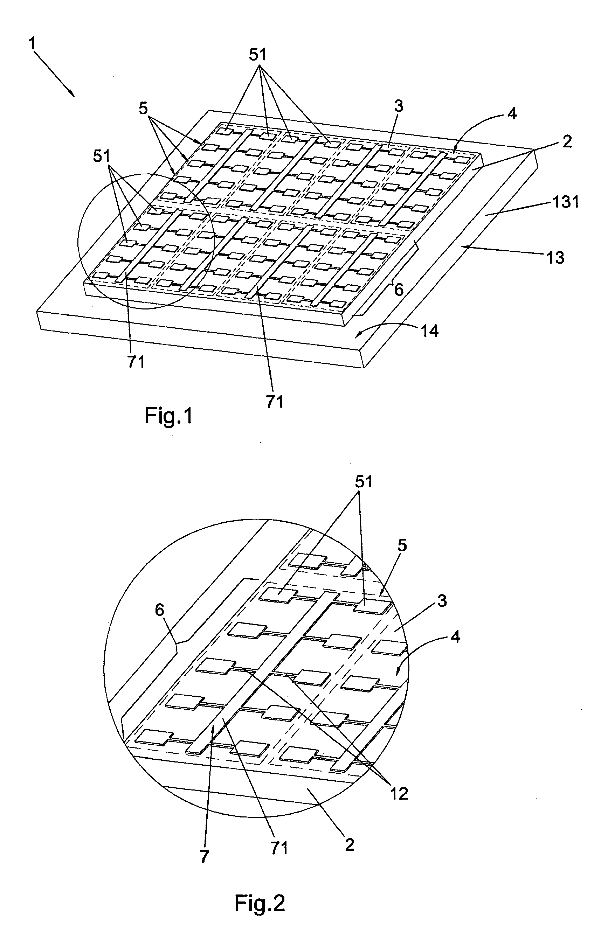

The silicon photomultiplier device (SiPM) for detecting one or more photons, to which the management method of the invention is applied, is represented as a whole in Figures 1, 3, 6 and 7, where it is indicated by **1.**

It can be observed in Figure 1 that the above mentioned photomultiplier device **1** comprises a sensitive surface **3** created on a first side **4** of a semiconductor substrate **2**.

In particular, the sensitive surface **3** comprises a plurality of Geiger-mode avalanche photodiodes **5** electronically insulated from one another.

As can be observed in Figure 2, according to the preferred embodiment of the photomultiplier device to which the management method of the invention is applied described herein, each photodiode **5** is connected in series to a resistor **12** usually made of polysilicon.

Said resistors **12**, as is well known, make it possible to dampen the avalanche effect (passive quenching circuit) that is generated in the corresponding photodiodes **5** at the moment when one or more photons result to be incident on the same photodiodes.

It cannot be excluded that in different construction forms said resistor **12** may not be present, as in the special case described further on in this document. Furthermore, in the preferred embodiment of the invention described herein and represented in the figures, the plurality of photodiodes **5** is arranged in a matrix.

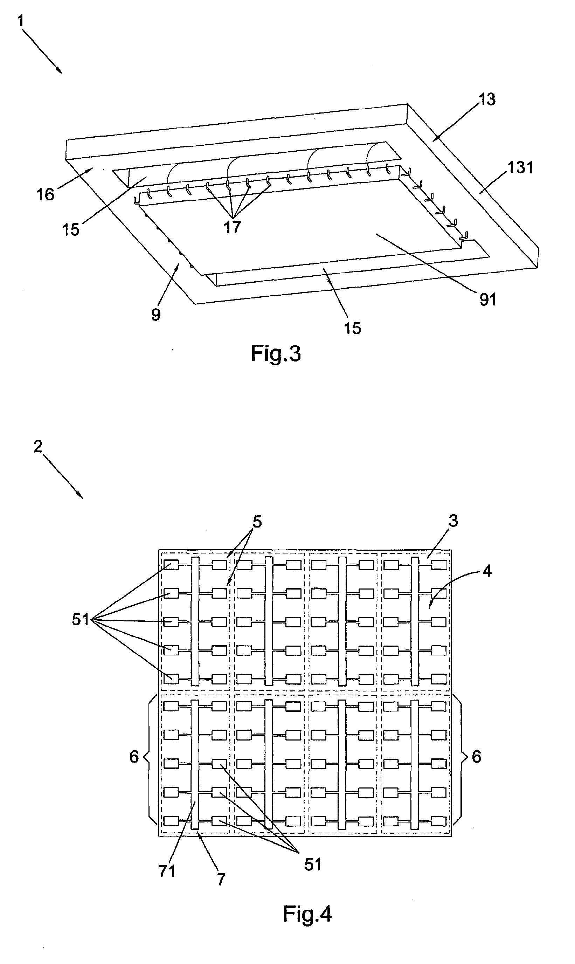

Nonetheless, in different construction forms the above mentioned photodiodes **5** can be arranged with a different configuration with respect to one another. Regarding the sensitive surface **3**, it is defined by a plurality of sectors **6**, each one of which comprises one or more photodiodes **51** belonging to the above mentioned plurality of photodiodes **5**, connected to one another in parallel, as shown in Figures 1 and 4 and in the detail of Figure 2.

The number of photodiodes **51** belonging to a single sector **6** is preferably but not necessarily less than twenty.

According to the preferred embodiment of the photomultiplier device to which the management method of the invention is applied described herein, each sector **6** comprises ten photodiodes **51** connected in parallel.

In a particular embodiment of the invention, each sector **6** may comprise a single photodiode **51** and in this case the resistor **12** may be absent, as previously mentioned.

It cannot be excluded, however, that in different embodiments the number of photodiodes **51** per sector **6** may exceed twenty.

Regarding the parallel connection of the photodiodes **51** belonging to each sector **6**, this is obtained through conductor means **7**.

As shown in Figures 2 and 4, in particular, said conductor means **7** comprise a metal strip **71** provided on the sensitive surface **3**.

In alternative embodiments of the invention it is not excluded that the connection of the above mentioned photodiodes **51** of a single sector **6** may be carried out with a different type of means or techniques, provided that they belong to the known art.

Regarding the sectors **6**, they are preferably but not necessarily present in a number lower than or equal to one hundred.

Also in this case, it cannot be excluded that the number of sectors **6** in which the sensitive surface **3** can be divided may exceed one hundred.

The parallel connection of the photodiodes **51** belonging to a single sector **6** makes it possible to define as output of the latter a resulting analog signal that is carried, through the same conductor means **7**, to an extraction point **81** belonging to a plurality of extraction points **8** electronically insulated from one another.

In their turn, as will be better explained below, the above mentioned extraction points **8** allow the pickup and successive processing, in an independent manner, of the individual analog signals defined by each sector **6** by a logic unit **9** illustrated in Figure 3.

According to the invention, the method for managing the photomultiplier device **1** described up to now makes it possible to inhibit one or more of said sectors **6**, in the case where one or more photodiodes **51** belonging to said sectors **6** are not operating or are noisy.

In particular, according to the preferred embodiment of the photomultiplier device **1** to which the management method of the invention is applied, as will be explained in detail below, said logic unit **9** is of the digital type.

In this case, said operation for inhibiting one or more sectors requires that the same malfunctioning sectors are disabled at a logic level.

In a different embodiment of the photomultiplier device **1** to which the management method of the invention is applied, as is described in detail here below, the logic unit **9** may be of the analog type.

In this case, said inhibition operation requires that the physical connection between the extraction points **8** corresponding to the malfunctioning sectors **6** and said logic unit **9** be disconnected.

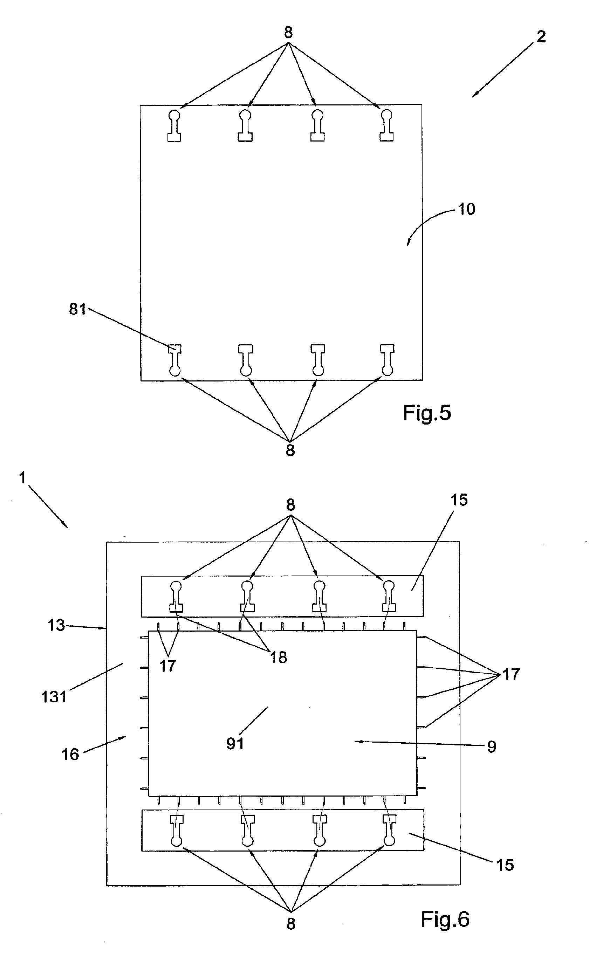

According to the preferred embodiment of the photomultiplier device to which the management method of the invention is applied described herein and illustrated in Figures **5** and **6**, said extraction points **8** are arranged on the second side **10** of the semiconductor substrate **2** opposite the first side **4** where the sensitive surface **3** is provided, and are therefore accessible from the same side **10**.

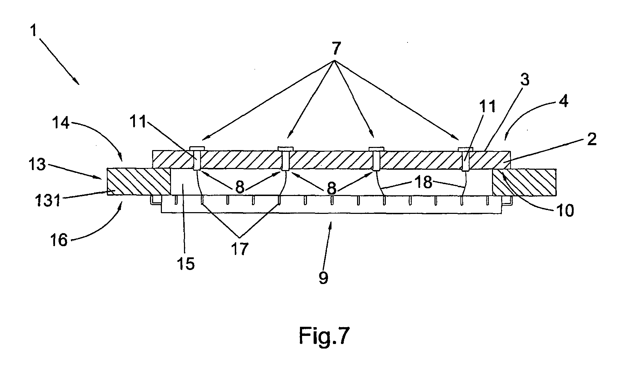

Said arrangement on the second side **10** of the extraction points **8** is made possible by means of conductor columns **11** carried out so that they pass through the semiconductor substrate **2**, each one of which intercepts the conductor means **7** of a specific sector **6** on said first side **4** and carries the analog signal to the opposite side, as shown in Figure 7.

With this configuration, advantageously, the whole sensitive surface **3** substantially presents the plurality of photodiodes **5** and no further elements, like for example the extraction points **8**, making it possible to increase the number of the same photodiodes **5** and consequently to increase the resolution of the entire photomultiplier device **1**, as shown in Figure 4.

It cannot be excluded that in different embodiments, neither described nor illustrated herein, the extraction points **8** may be located on the same sensitive surface **3**, negatively affecting, however, the resolution of the photomultiplier device **1** of the invention.

Regarding the photomultiplier device **1** to which the management method of the invention is applied, in the preferred embodiment described herein and illustrated in Figures **1**, **3** and **7**, it comprises a substantially plate-like dielectric support element **13** that is coupled with the second side **10** of said semiconductor substrate **2** at the level of a first face **14**.

In particular, therefore, in the preferred embodiment of the invention the extraction points **8** of the analog signals face towards said dielectric support element **13**.

Obviously, in order to make said extraction points **8** accessible from the outside, one or more through openings **15** are created in the dielectric support element **13**, as shown in Figures **3**, **6** and **7**.

Thanks to this configuration, with the preferred embodiment of the invention it is possible to arrange the logic unit **9** on the second face **16** of the dielectric support element **13**, opposite said first face **14**.

In its turn, the logic unit **9** comprises a plurality of inputs **17**, each one of which is suited to be connected to one of the extraction points 8 accessible through said one or more openings **15**.

In particular, according to the preferred embodiment of the photomultiplier device **1** to which the management method of the invention is applied, as shown in Figure **6**, the electronic connection between each input **17** of the logic unit **9** and the corresponding extraction point **8** is carried out through wire bonds **18**.

In different embodiments of the invention, said connection may be carried out with different techniques or means, provided that they belong to the known art. Regarding the dielectric support element **13**, in the preferred embodiment of the photomultiplier device **1** to which the management method of the invention is applied described herein, it is a printed circuit board (PCB) **131**.

In different embodiments of the invention, neither described nor illustrated herein, said dielectric support element **13** may be made with a ceramic material or a different material, provided that it is of the dielectric type.

As already mentioned, in the preferred embodiment of the invention the logic unit **9** is arranged on the second face **16** of the dielectric support element **13** opposing the semiconductor substrate **2**.

It cannot be excluded, however, that in different embodiments said logic unit **9** may be external to the photomultiplier device **1** and connected to the plurality of extraction points **8** through discrete connection means (wires).

As already mentioned, according to the preferred embodiment of the photomultiplier device **1** to which the management method of the invention is applied, the logic unit **9** comprises an integrated circuit **91** specifically designed (ASIC) with a digital processing logic, so as to output multiple data concerning, for example, the number and time of arrival of the incident photons.

Furthermore, said type of integrated circuit **91** can be used as a control unit by acting on the power supply voltage of the individual photodiodes 5 in order to cope with possible fluctuations due to temperature changes or to non conformities between the devices.

Furthermore, said type of logic unit **9**, as already explained, makes it possible to inhibit the individual sectors **6** that are not operating or are particularly noisy. In the limit case, neither described nor illustrated herein, of a single photodiode **51** per sector **6** the dielectric support element **13** may not be provided, while on the other hand the integrated circuit **91** and the semiconductor substrate 2 may be directly coupled with each other by connecting the extraction points 8 of the individual sectors **6** to the inputs **17** of the same integrated circuit 91 through a "bump-bonding" process.

In different embodiments it cannot be excluded that said integrated circuit **91** may comprise one or more amplifiers/adders, exclusively of the analog type, giving as an output a resulting analog signal proportional to the number of photodiodes **5** that reacted to the incidence of the photons.

In this way the signals coming from the sensitive surface **3** are managed by a considerably simplified logic unit **9**, thus granting an advantage from both the productive and the economic point of view compared to the logic units of the digital type described above.

In greater detail, as already explained, in the case of the logic unit **9** of the analog type, it is simply omitted to connect any non operating or excessively noisy sectors **6** to the corresponding input **17** of the logic unit **9**.

The identification of said non operating or excessively noisy sectors 6 can be carried out quickly through automatic current measurements on the entire semiconductor substrate **2**.

Furthermore, with the method of the invention concerning the management of the photomultiplier device **1** configured as described above, the amplification of the analog signal of the individual sectors **6** grants some advantages also in terms of timing performance compared to the analog photomultiplier devices of the known art.

In fact, each amplifier works on a photodiode **5** with reduced parasitic capacity and therefore it is easier to have signal to noise ratios (SNR) suited to the desired timing performance.

Furthermore, the above mentioned logic unit **9**, in alternative embodiments not illustrated in the figures, may comprise discrete components.

In particular, said discrete components may, as in the case of the integrated circuit **91**, implement a digital logic, giving as output, in fact, a digital signal or an analog logic and clearly generating an analog signal.

In general, independently of the type of logic unit **9** used, it makes it possible to implement different and multiple functions with no need to reduce the sensitive surface **3**, as the logic unit **9** first of all is independent of said sensitive surface **3** and furthermore is located on the opposite side with respect to the dielectric support element **13**, as already explained.

Furthermore, thanks to the connection of the same logic unit **9** to the second face **16** of the dielectric support element **13**, it is easier to integrate the photomultiplier device **1** in a modular system.

On the basis of the above, it is clear that the method of the invention concerning the management of a photomultiplier device that is the subject of the invention achieves all the set objects.

In particular, the invention achieves the object to propose a method for managing a silicon photomultiplier device that makes it possible to inhibit in a simple manner a sector or, in the limit case, an individual noisy or non operating photodiode that determine the reduction of the overall efficiency.

In the same time, the invention also achieves the object to propose a method for managing a photomultiplier device whose the sensitive surface is independent of the logic unit, so as to allow separate intervention on the two entities.

Another object achieved is to propose a method for managing a photomultiplier device whose sensitive surface has reduced dimensions, though maintaining high resolution.

Finally, the invention also achieves the object to propose a method for managing a photomultiplier device whose efficiency and temporal resolution can be compared to those of digital photomultipliers.

On implementation, the method of the invention concerning the management of a photomultiplier device may undergo further changes that, though not illustrated or described herein, shall nonetheless be covered by the present patent, provided that they come within the scope of the claims that follow. Where technical features mentioned in any claim are followed by reference signs, those reference sings have been included for the sole purpose of increasing the intelligibility of the claims and accordingly such reference signs do not have any limiting effect on the protection of each element identified by way of example by such reference signs.

## Claims

1. Method for managing a silicon photomultiplier device (SiPM) (1) for detecting one or more photons, of the type comprising a surface (3) that is sensitive to said photons, provided on a first side (4) of a semiconductor substrate (2) and defined by a plurality of sectors (6) each one of which comprises a plurality of photodiodes (5) operating in Geiger mode and connected to each other in parallel through conductor means (7), so as to define an analog output signal, said semiconductor substrate (2) comprising a plurality of extraction points (8) electronically insulated from one another, each one of which is suited to be connected to a corresponding sector (6) through conductor means (7) so that said analog signals can be picked up and processed in an independent manner by a logic unit (9), **characterized in that** one or more of said sectors (6) are inhibited in the case where at least one of said photodiodes (5) belonging to said one or more sectors (6) is not operating or is noisy.

2. Method according to claim 1), wherein said operation for inhibiting said one or more sectors (6) requires that said one or more sectors (6) are disabled at a logic level, in the case where said logic unit (9) is of the digital type.

3. Method according to claim 1), wherein said operation for inhibiting said one or more sectors (6) requires that the physical connections between said one or more extraction points (8) corresponding to said one or more sectors (6) and said logic unit (9) are disconnected, in the case where said logic unit (9) is of the analog type.

4. Method according to any of the preceding claims, wherein said logic unit (9) outputs at least one resulting signal proportional to the number of said photons.

5. Method according to claim 4), wherein said logic unit (9) outputs also data concerning the detection time for said photons.

6. Method according to any of the preceding claims, wherein said extraction points (8) are located on the second side (10) of said semiconductor substrate (2) opposite said first side (4) where said sensitive surface (3) is arranged through the connection with conductor columns (11) carried out so that they pass through said semiconductor substrate (2).

7. Method according to any of the preceding claims, wherein said conductor means (7) comprise a metal strip (71) provided on said sensitive surface (3) for connecting in parallel said photodiodes (5) belonging to each one of said sectors (6).

8. Method according to any of the preceding claims, wherein said photomultiplier device (1) comprises a substantially plate-like dielectric support element (13) coupled, at the level of a first one (14) of its faces, to said second side (10) of said semiconductor substrate (2), and, at the height of its second face (16) opposite said first face (14), to said logic unit (9) having a plurality of inputs (17), each one of which is suited to be connected to one of said extraction points (8).

9. Method according to claim 8), wherein said photomultiplier device (1) comprises a plurality of wire bonds (18) arranged so that they pass through one or more openings (15) defined in said dielectric support element (13) and suited to connect each one of said inputs (17) to a corresponding extraction point (8).

10. Method according to claim 8) or 9), wherein said dielectric support element (13) is a printed circuit board (PCB) (131).

11. Method according to any of the preceding claims, wherein each one of said sectors (6) comprises said photodiodes (5) in a number under twenty.

12. Method according to any of the preceding claims, wherein said photomultiplier device (1) comprises a polysilicon resistor (12) connected in series between each one of said photodiodes (5) and the corresponding conductor means (7).

13. Method according to any of the preceding claims, wherein said logic unit (9) is an integrated circuit (91).

14. Method according to any of the preceding claims, wherein said logic unit (9) is of the digital type.

15. Method according to any of the claims from 1) to 13), wherein said logic unit (9) comprises one or more amplifiers/adders of the analog type.

## Patentansprüche

1. Methode zur Steuerung einer Silicon-Photomultiplier-Vorrichtung (SiPM) (1) zur Erkennung eines oder mehrerer Photonen, des Typs, der eine Oberfläche (3) umfasst, die gegenüber den besagten Photonen empfindlich, an einer ersten Seite (4) mit einem Halbleitersubstrat (2) versehen und durch eine Vielzahl von Abschnitten (6) definiert ist, von denen ein jeder eine Vielzahl von Photodioden (5) umfasst, die im Geiger-Modus arbeiten und über Leitmittel (7) parallel miteinander verbunden sind, so dass sie ein Analog-Ausgangssignal definieren, wobei das besagte Halbleitersubstrat (2) eine Vielzahl elektronisch voneinander isolierter Auszugspunkte (8) umfasst, von denen ein jeder geeignet ist, durch Leitmittel (7) mit einem entsprechenden Abschnitt (6) verbunden zu werden, so dass die besagten Analogsignale erfasst und auf unabhängige Weise durch eine Logikeinheit (9) verarbeitet werden können, **dadurch gekennzeichnet, dass** einer oder mehrere der besagten Abschnitte (6) gehemmt werden, wenn wenigstens eine der besagten, zu einem oder mehreren Abschnitten (6) gehörigen Photodioden (5) nicht arbeitet oder laut ist.

2. Methode gemäß Patentanspruch 1), wobei der besagte Vorgang zur Hemmung des/der besagten, einen oder mehreren Abschnitts/Abschnitte (6) die Deaktivierung des/der besagten, einen oder mehreren Abschnitts/ Abschnitte (6) auf einem logischen Niveau erfordert, wenn die besagte Logikeinheit (9) vom digitalen Typ ist.

3. Methode gemäß Patentanspruch 1), wobei der besagte Vorgang zur Hemmung des/der besagten, einen oder mehreren Abschnitte (6) die Abtrennung der physischen Verbindungen zwischen dem/den besagten einen oder mehreren, zu dem/den besagten einem oder mehreren Abschnitt/ Abschnitten (6) entsprechenden Auszugspunkt(en) (8) und der besagten Logikeinheit (9) erfordert, wenn die besagte Logikeinheit (9) vom analogen Typ ist.

4. Methode gemäß eines jeden der vorstehenden Patentansprüche, wobei die besagte Logikeinheit (9) wenigstens ein resultierendes Signal ausgibt, das proportional zur Anzahl der besagten Photonen ist.

5. Methode gemäß Patentanspruch 4), wobei die besagte Logikeinheit (9) auch Daten über die Dauer der Erfassung der besagten Photone ausgibt.

6. Methode gemäß eines jeden der vorstehenden Patentansprüche, wobei die besagten Auszugspunkte (8) an der zweiten, der besagten ersten Seite (4) gegenüberliegenden Seite (10) des besagten Halbleitersubstrats (2) positioniert sind, wo die besagte, empfindliche Oberfläche (3) unter Verbindung mit leitenden Säulen (11) angebracht ist, welche derart ausgeführt sind, dass sie durch das besagte Halbleitersubstrat (2) verlaufen.

7. Methode gemäß eines jeden der vorstehenden Patentansprüche, wobei die besagten Leitmittel (7) einen Metallstreifen (71) umfassen, der an der besagten, empfindlichen Oberfläche (3) für die Parallelverbindung der besagten, zu jedem der besagten Abschnitte (6) gehörigen Photodioden (5) vorhanden ist.

8. Methode gemäß eines jeden der vorstehenden Patentansprüche, wobei die besagte Photomultiplier-Vorrichtung (1) ein im Wesentlichen plattenartiges, dielektrisches Trägerelement (13) umfasst, das auf Ebene einer ersten (14) seiner Seiten an die besagte zweite Seite (10) des besagten Halbleitersubstrats (2) gekuppelt ist und auf Höhe seiner zweiten Seite (16), die der besagten ersten Seite (14) entgegengesetzt ist, an die besagte Logikeinheit (9), welche eine Vielzahl von Eingängen (17) aufweist, von denen jeder geeignet ist, an einen der besagten Auszugspunkte (8) angeschlossen zu werden.

9. Methode gemäß Patentanspruch 8), wobei die besagte Photomultiplier-Vorrichtung (1) eine Vielzahl von Bonddrähten (18) umfasst, die so angeordnet sind, dass sie durch eine oder mehrere Öffnungen (15) verlaufen, die in dem besagten dielektrischen Trägerelement (13) definiert sind und geeignet sind, jeden der besagten Eingänge (17) mit einem entsprechenden Auszugspunkt (8) zu verbinden.

10. Methode gemäß Patentanspruch 8) oder 9), wobei das besagte dielektrische Trägerelement (13) eine Platine (PCB) (131) ist.

11. Methode gemäß eines jeden der vorstehenden Patentansprüche, wobei jeder der besagten Abschnitte (6) eine Anzahl von weniger als zwanzig der besagten Photodioden (5) umfasst.

12. Methode gemäß eines jeden der vorstehenden Patentansprüche, wobei die besagte Photomultiplier-Vorrichtung (1) einen Polysilikonwiderstand (12) umfasst, der in Reihe zwischen jeder der besagten Photodioden (5) und den entsprechenden Leitmitteln (7) angeschlossen ist.

13. Methode gemäß eines jeden der vorstehenden Patentansprüche, wobei die besagte Logikeinheit (9) ein integrierter Schaltkreis (91) ist.

14. Methode gemäß eines jeden der vorstehenden Patentansprüche, wobei die besagte Logikeinheit (9) vom digitalen Typ ist.

15. Methode gemäß eines jeden der Patentansprüche von 1) bis 13), wobei die besagte Logikeinheit (9) einen oder mehrere Verstärker/Addierer vom analogen Typ umfasst.

## Revendications

1. Méthode pour la gestion d'un dispositif photomultiplicateur silicium (SiPM) (1) pour la détection d'un ou plusieurs photons du type comprenant une surface (3) sensible auxdits photons, réalisée sur un premier côté (4) d'un substrat semi-conducteur (2) et définie par une pluralité de secteurs (6) chacun desquels comprend une pluralité de photodiodes (5) fonctionnant en mode Geiger et reliées entre elles en parallèle par des moyens conducteurs (7) de manière à définir un signal de sortie analogique, ledit substrat semi-conducteur (2) comprenant une pluralité de points d'extraction (8) électriquement isolés entre eux, chacun desquels est apte à être relié à un secteur correspondant (6) par des moyens conducteurs (7) de façon à ce que lesdits signaux analogiques puissent être pris et traités d'une manière indépendante par une unité logique (9), **caractérisée en ce qu'**un ou plusieurs desdits secteurs (6) sont désactivés au cas où au moins une desdites photodiodes (5) appartenant auxdits un ou plusieurs secteurs (6) ne fonctionnerait pas ou résulterait bruyante.

2. Méthode selon la revendication 1), où ladite opération d'inhibition desdits un ou plusieurs secteurs (6) prévoit que lesdits un ou plusieurs secteurs (6) sont désactivés à niveau logique, au cas où ladite unité logique (9) serait du type numérique.

3. Méthode selon la revendication 1), où ladite opération d'inhibition desdits un ou plusieurs secteurs (6) prévoit la désactivation des connexions physiques entre lesdits un ou plusieurs points d'extraction (8) correspondant auxdits un ou plusieurs secteurs (6) et ladite unité logique (9), au cas où ladite unité logique (9) serait du type analogique.

4. Méthode selon l'une quelconque des revendications précédentes, où ladite unité logique (9) produit en sortie au moins un signal résultant proportionnel au numéro desdits photons.

5. Méthode selon la revendication 4), où ladite unité logique (9) produit en sortie aussi des données relatives au temps de détection desdits photons.

6. Méthode selon l'une quelconque des revendications précédentes, où lesdits points d'extraction (8) sont positionnés sur le deuxième côté (10) dudit substrat semi-conducteur (2) opposé audit premier côté (4) où ladite surface sensible (3) est disposée par la connexion avec des colonnes conductrices (11) réalisées de façon à ce qu'elles passent à travers ledit substrat semi-conducteur (2).

7. Méthode selon l'une quelconque des revendications précédentes, où lesdits moyens conducteurs (7) comprennent une bande métallique (71) réalisée sur ladite surface sensible (3) pour la connexion en parallèle desdits photodiodes (5) appartenant à chacun desdits secteurs (6).

8. Méthode selon l'une quelconque des revendications précédentes, où ledit dispositif photomultiplicateur (1) comprend un élément de support diélectrique (13) essentiellement laminaire accouplé, à hauteur d'une première parmi ses faces (14), audit deuxième côté (10) dudit substrat semi-conducteur (2) et, à hauteur de sa deuxième face (16) opposée à ladite première face (14), à ladite unité logique (9) ayant une pluralité d'entrées (17), chacune desquelles est apte à être reliée à un desdits points d'extraction (8).

9. Méthode selon la revendication 8), où ledit dispositif photomultiplicateur (1) comprend une pluralité de câblages filaires (18) disposés de façon à passer à travers une ou plusieurs ouvertures (15) définies dans ledit élément de support diélectrique (13) et aptes à relier chacune desdites entrées (17) à un point d'extraction correspondant (8).

10. Méthode selon l'une quelconque des revendications précédentes 8) ou 9), où ledit élément de support diélectrique (13) est une carte à circuits imprimés (PCB) (131).

11. Méthode selon l'une quelconque des revendications précédentes, où chacun desdits secteurs (6) comprend lesdits photodiodes (5) dans un numéro inférieur à vingt.

12. Méthode selon l'une quelconque des revendications précédentes, où ledit dispositif photomultiplicateur (1) comprend une résistance (12) de polysilicium reliée en série entre chacun desdits photodiodes (5) et les moyens conducteurs correspondants (7).

13. Méthode selon l'une quelconque des revendications précédentes, où ladite unité logique (9) est un circuit intégré (91).

14. Méthode selon l'une quelconque des revendications précédentes, où ladite unité logique (9) est du type numérique.

15. Méthode selon l'une quelconque des revendications de 1) à 13), où ladite unité logique (9) comprend un ou plusieurs amplificateurs/ additionneurs du type analogique.
